# FASCICULE DE BREVET EUROPEEN

(11) **EP 1 788 646 B1**
(45) Date de publication et mention de la délivrance du brevet: **19.03.2008**
(21) Numéro de dépôt: 06291754.7
(22) Date de dépôt: 13.11.2006
(51) Int. Cl.: H01L 41/09, B64C 3/38

(54) **Actionneur plan à structure sandwich et application à la torsion de structure**
Planarer Aktor mit Sandwich-Aufbau und Anwendung zur Torsion einer Struktur
Planar sandwich type actuator and application for torsion of a structure

(30) Priorité: 22.11.2005 FR 0511787
(43) Date de publication de la demande: 23.05.2007
(73) Titulaire: ONERA (Office National d'Etudes et de Recherches Aérospatiales), 92300 Châtillon (FR)
(72) Inventeur: Mercier des Rochettes, Hugues, 59910 Bondues (FR); Buchaniek, Léon, 59890 Quesnoy sur Deûle (FR); Joly, Didier, 59184 Sainghin en Weppes (FR)
(74) Mandataire: Bonnetat, Christian

(56) Documents cités:
- EP-B- 0 822 602
- WO-A-00/51190
- WO-A-01/33648
- US-A- 5 869 189
- CESNIK C E S ET AL: "Modeling, design, and testing of the NASA/Army/MIT active twist rotor prototype blade" PROCEEDINGS 55TH ANNUAL FORUM OF THE AMERICAN HELICOPTER SOCIETY, MONTREAL, CANADA, MAY 25-27, 1999, pages 533-544, XP009069472
- RODGERS J P ET AL: "Preliminary Mach-scale hover testing of an integral twist-actuated rotor blade" SMART STRUCTURES AND INTEGRATED SYSTEMS, SAN DIEGO, CA, USA, 2-5 MARCH 1998, PROCEEDINGS OF THE SPIE, vol. 3329, 1998, pages 291-308, XP002389450

## Description

La présente invention concerne un actionneur actif apte à fournir un déplacement transverse de cisaillement dans un plan, un dispositif mettant en oeuvre deux actionneurs de ce type et son application à la torsion de structure.

Elle porte plus particulièrement sur un actionneur actif plan à structure sandwich comportant au moins une couche plane piézoélectrique ayant une direction active superposée et solidarisée à au moins une couche plane passive de tissu à chaîne et trame rigides formant un maillage. La direction active de la couche piézoélectrique est orientée de façon particulière par rapport au maillage des couches de tissu.

L'invention s'applique à la torsion active de structures comme, par exemple, une pale d'hélicoptère.

En aéronautique, le souci d'améliorer la maniabilité, la sécurité ou de diminuer les nuisances sonores conduit les concepteurs d'aéronef à mettre en oeuvre de plus en plus souvent des éléments de voilure actifs. Ces éléments sont aptes à se déformer de façon contrôlée en réponse à une consigne précise, afin de modifier le comportement des aéronefs dans leur environnement.

Ainsi, le gauchissement contrôlé de surfaces portantes d'aéronefs a fait l'objet de nombreuses études et a donné lieu à la réalisation d'actionneurs permettant un déplacement relatif de la surface supérieure ou extrados par rapport à la surface inférieure ou intrados.

Outre les actionneurs mécaniques et hydrauliques comme présenté par De Laurier et al. (US 5,288,039) ou Young et al. (US 6,173,924), on peut aussi citer les actionneurs piézoélectriques qui intéressent plus particulièrement l'invention tels que décrits par Jeffs et al. (GB 2 348 537) ou par Matthew L. Wilbur et al. (« Hover testing of the NASA/ARMY/MIT active twist rotor prototype blade » ; the American Helicopter Society 56th Annual Forum, Virginia Beach, Virginia, May 2-4, 2000) ou encore dans le brevet français au nom du demandeur (FR 2.833.571).

Dans le brevet anglais GB-2 348 537, les bords de fuite de l'extrados et de l'intrados sont solidarisés entre eux par le biais d'un tube fendu parallèlement au bord de fuite selon l'envergure de la voilure. Les deux lèvres de la fente sont aménagées pour recevoir des actionneurs piézoélectriques qui sont aptes à faire glisser une lèvre par rapport à l'autre selon l'envergure. Compte tenu de la faible valeur de l'élongation disponible, le déplacement relatif des bords de fuite est trop faible pour permettre un gauchissement contrôlé efficace de la voilure.

Dans les travaux de Matthew L. Wilbur ou Carlos C.E.S. Cesuik et al. (« Modeling, design, and testing of the NASA/ARMY/MIT active twist rotor prototype blade », American Helicopter Society 55th Annual Forum, Montreal, Canada, May 25-27, 1999), une pale d'hélicoptère est équipée, à six endroits répartis selon son envergure tous situés dans la zone d'épaisseur maximale quasi plane, de deux actionneurs piézoélectriques, un dans l'extrados, l'autre dans l'intrados. Chaque actionneur comporte deux couches piézoélectriques du type MFC (Macro Fiber Composite), aptes chacune à s'allonger ou se contracter selon une direction active. Une première couche centrale de tissu de verre est prise en sandwich entre deux couches piézoélectriques. Les directions actives des couches piézoélectriques sont orientées respectivement selon la chaîne et la trame du tissu de verre. Ce premier sandwich est lui même pris en sandwich entre deux autres couches de tissu de verre dont la chaîne et la trame sont orientées selon les diagonales de la chaîne et de la trame du tissu de la couche centrale, donc des directions actives. C'est ce sandwich à cinq couches qui constitue un actionneur.

Lorsqu'un actionneur quasi plan est activé, il se déforme spontanément en torsion, induisant directement le gauchissement de la pale. Le fait d'avoir disposé des ensembles à l'intrados et à l'extrados amplifie le gauchissement de la pale. Outre la difficulté d'implantation de tels ensembles dans la structure de la pale, ils sont situés dans une section fermée, dite « D-spar », présentant une rigidité en torsion élevée qui oppose une forte résistance aux déformations des actionneurs, créant ainsi de fortes contraintes entre les couches qui les constituent. De plus, ces actionneurs étant situés sur les peaux intrados et extrados, au niveau de l'épaisseur maximale du profil, ils subissent donc aussi de fortes contraintes lorsque la pale est sollicitée en flexion de battement.

Afin de limiter cette résistance, dans le brevet français au nom du demandeur (FR 2.833.571), les bords de fuite intrados et extrados sont, selon une variante de réalisation, directement reliés à des actionneurs piézoélectriques fonctionnant en cisaillement et refermant continûment la section selon l'envergure afin d'obtenir une forte rigidité de torsion. Mais, pour préserver cette rigidité, les actionneurs sont nécessairement implantés à proximité du bord de fuite où l'épaisseur de la voilure est faible, ce qui limite la dimension de l'actionneur selon l'épaisseur du profil. Compte tenu de la faible valeur de l'angle de cisaillement, le déplacement relatif des bords de fuite ainsi disponible est trop faible pour permettre un gauchissement contrôlé efficace de la voilure.

Il était donc souhaitable pour le demandeur de pouvoir mettre en oeuvre un dispositif qui referme continûment la section de la pale, assure une forte rigidité en torsion, ait des contraintes internes limitées lorsque la pale est soumise à des charges extérieures et permette une course importante entre les deux bords de fuite de l'extrados et de l'intrados selon l'envergure.

La présente invention a pour objet un actionneur plan apte à se déformer en cisaillement et un dispositif mettant en oeuvre deux actionneurs selon l'invention montés tête-bêche aptes à se déformer en cisaillement chacun dans leur plan. Elle concerne aussi l'implantation particulière d'un tel dispositif dans une structure de pale d'hélicoptère dont il referme continûment la section initialement ouverte.

L'actionneur, élément constitutif du dispositif de l'invention, est de type plan à structure sandwich comportant deux zones de fixation destinées à transmettre le déplacement relatif en cisaillement généré par l'actionneur et au moins trois couches planes superposées comprenant au moins une couche d'un tissu dont la chaîne et la trame sont constituées de fibres rigides disposées selon deux directions du plan, formant un maillage de parallélogrammes juxtaposés, et au moins une couche plane active piézoélectrique apte à s'allonger ou se rétracter selon une direction active, chaque face d'une couche étant collée sur toute sa surface à une face de la couche adjacente. Dans l'actionneur de l'invention, la structure sandwich est symétrique par rapport au plan médian de l'actionneur favorisant ainsi une déformation plane en cisaillement, la direction active de chaque couche plane piézoélectrique est orientée selon une seule et même diagonale du maillage de chaque couche de tissu dont la chaîne et la trame sont orientées selon deux directions du plan, les zones de fixation de l'actionneur, de forme allongée selon une première des deux directions du plan, sont disposées le long des extrémités opposées de l'actionneur selon la seconde direction du plan, ce grâce à quoi, chaque couche plane de tissu étant sollicitée selon une seule diagonale du maillage, les parallélogrammes se déforment entraînant le déplacement dans le plan des zones de fixation parallèlement l'une à l'autre selon la première direction du plan.

Selon une première réalisation, l'actionneur comporte deux couches de tissu prenant en sandwich une couche plane active.

Selon une deuxième réalisation, l'actionneur comporte une couche de tissu prise en sandwich entre deux couches planes actives qui s'allongent et se rétractent ensemble.

L'invention concerne aussi un dispositif comportant l'empilement de deux actionneurs montés tête-bêche, deux des zones de fixation en vis-à-vis des actionneurs étant solidarisées et les deux directions actives n'étant pas parallèles, les deux autres zones de fixation des actionneurs laissées libres se déplacent parallèlement en sens inverse selon la première direction du plan avec une amplitude égale à la somme des déplacements des deux actionneurs.

L'invention concerne encore l'implantation du dispositif dans une structure de pale d'hélicoptère, une zone de fixation libre étant solidaire de l'extrados, l'autre zone de fixation libre étant solidaire de l'intrados.

Selon une première réalisation d'implantation, le dispositif est situé entre l'extrados et l'intrados, à l'intérieur de la pale, dans le plan de la corde. Deux zones de fixation sont directement solidarisées l'une à l'autre, les deux autres zones de fixation sont solidarisées respectivement à l'intrados et à l'extrados, à proximité immédiate du bord de fuite. La hauteur du dispositif est alors minimale, ce qui facilite son intégration sans pour autant en limiter la course.

Selon une deuxième réalisation d'implantation, le dispositif est placé dans le prolongement respectivement de l'intrados et de l'extrados. Il constitue le bord de fuite de la pale, dont il referme continûment la section initialement ouverte. I1 est alors composé de deux actionneurs plans dont deux zones de fixation sont solidarisées l'une à l'autre, les plans respectifs des actionneurs formant entre eux l'angle du bord de fuite souhaité pour la pale, les deux autres zones de fixation sont solidarisées respectivement aux extrémités libres de l'intrados et de l'extrados.

Les figures du dessin annexé feront bien comprendre comment l'invention peut être réalisée. Sur ces figures, des références identiques désignent des éléments semblables.

La figure 1 est une vue schématique d'un actionneur conforme à l'invention, au repos.

La figure 2 illustre la déformation en cisaillement de l'actionneur de la figure 1, lorsqu'il est activé.

La figure 3 présente les diagrammes de cisaillement caractéristiques d'un actionneur de l'invention.

La figure 4 est une vue schématique d'un dispositif conforme à l'invention, au repos.

La figure 5 représente la déformation en cisaillement du dispositif de la figure 4, lorsqu'il est activé.

La figure 6 est une vue perspective au repos d'un tronçon de pale d'hélicoptère dans lequel est implanté le dispositif selon une première réalisation.

La figure 7 illustre le fonctionnement du dispositif selon cette première réalisation.

La figure 8 montre les diagrammes de cisaillement caractéristiques du dispositif implanté dans la pale.

La figure 9 est une coupe du dispositif dans une pale d'hélicoptère selon une deuxième réalisation.

### Exemple 1

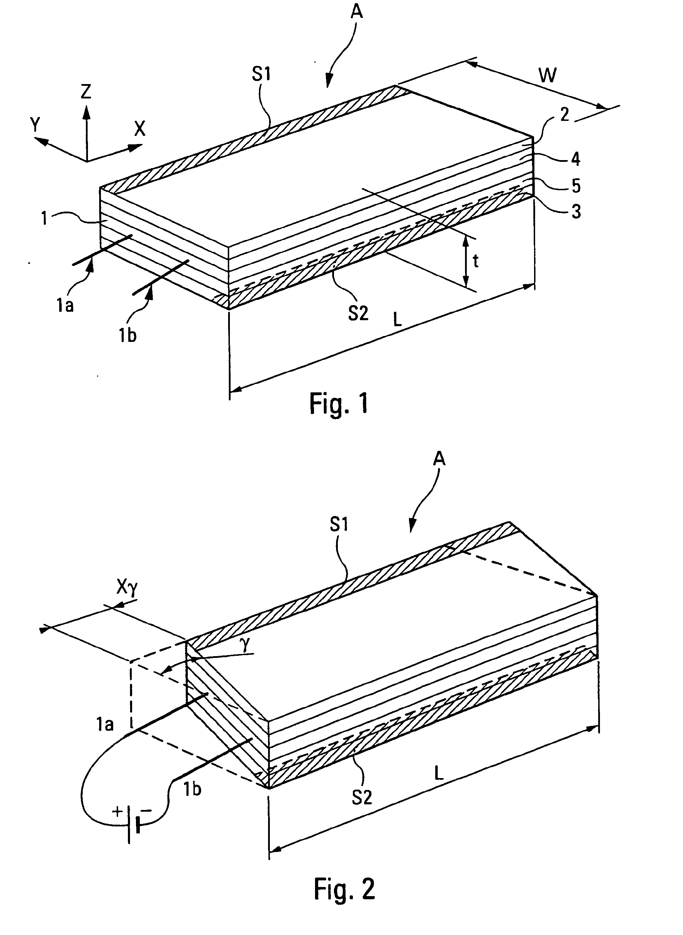

L'actionneur plan à structure sandwich A, conforme à la présente invention et montré par la figure 1 présente une épaisseur t suivant la direction Z, une longueur L suivant la direction X et une largeur W suivant la direction Y. Cet actionneur est constitué des éléments suivants :

Dans le plan central se trouve une couche plane active piézoélectrique 1 apte à s'allonger ou se rétracter suivant la bissectrice des directions X et Y lorsqu'elle est alimentée en tension. Cette couche piézoélectrique est constituée de fibres rectangulaires unidirectionnelles piézoélectriques orientées suivant la bissectrice des directions X et Y et alimentées en tension par des électrodes 1a et 1b. Les fibres sont prises en sandwich entre des couches d'époxy structural et des films polyamides intégrant les électrodes inter-digitées perpendiculaires aux fibres. L'ensemble a une épaisseur d'environ 0.3 mm et une surface rectangulaire active de 85 x 57 mm² par exemple. L'inconvénient de ce type de couche est qu'elle est très mince et donc sensible au flambage. Un autre inconvénient concerne son allongement suivant la direction X qui peut poser des problèmes dans les zones de collage des zones de fixation avec leur supports, en particulier si ceux-ci sont très rigides. La contrainte de cisaillement peut alors entraîner la rupture du joint de colle.

Sur le dessus de toute la surface de ladite couche plane active est placé un premier tissu 2 de 0.2 mm, par exemple de type taffetas, dont les fibres sont en matériau à haut module, comme par exemple du carbone HM. Ce tissu a une trame et une chaîne orientées respectivement selon la direction X et la direction Y. La trame et la chaîne définissent un maillage de parallélogrammes juxtaposés.

Sur le dessous de toute la surface de ladite couche plane active est placé un second tissu 3 identique au premier tissu 2 et orienté de la même façon.

Deux joints de colle 4 et 5 sont disposés entre les trois couches pour les lier entre elles. Ces joints de colle ont une épaisseur réglée à 0.1 mm au moyen d'une grille textile souple et un module de Young approprié de façon à transmettre au mieux le déplacement de cisaillement de ladite couche plane active piézoélectrique 1 audits tissus 2 et 3.

Une zone de fixation S1 est orientée selon la trame des tissus et s'étend le long d'une extrémité selon la chaîne de ces mêmes tissus. Elle est située par exemple sur une face extérieure de l'actionneur.

L'autre zone de fixation S2 est orientée selon la trame des tissus et s'étend le long de l'autre extrémité selon la chaîne de ces mêmes tissus. Elle est située par exemple sur l'autre face extérieure de l'actionneur.

Le principe de fonctionnement de l'actionneur est que, lorsque la couche plane active 1 est alimentée en tension par les électrodes 1a et 1b, elle génère selon la bissectrice des directions X et Y, dans le plan X-Y, une extension qui se transmet grâce aux joints de colle aux deux tissus composites 2 et 3. Les parallélogrammes du maillage des tissus, sollicités suivant la même diagonale, se déforment. Cette déformation se transforme en un angle de cisaillement γ par rapport à la direction Y comme illustré par la figure 2 et la couche plane active 1 fournit un déplacement en cisaillement X_{γ} = γ × W suivant l'axe X comme indiqué sur ladite figure 2.

L'actionneur s'allonge peu suivant la direction X car la trame du tissu s'y oppose. Les joints de colle sont donc peu sollicités. De même, l'actionneur s'allonge peu suivant la direction Y car la chaîne du tissu s'y oppose. L'actionneur se déforme peu selon la direction Z car il est symétrique et la résultante des forces mises en jeu est dans le plan X-Y.

Un tel actionneur a été fabriqué avec, comme couche plane active, une MFC de section active 85 × 57 × 0.3 mm³ prise en sandwich entre deux tissus de carbone SXM10 et a été testé en fonctionnement sous +/-750 Volts.

Au moyen d'une rosette de trois jauges collée au centre de la couche plane active, il a été mesuré :
- les déformations suivant la direction X ;
- les déformations suivant la direction Y ;
- les déformations de cisaillement γ.

Il a été aussi mesuré au moyen d'un capteur optique les déplacements des quatre coins de l'actionneur qui, rapportés à sa largeur W, permettent de déduire les déformations en cisaillement.

Les résultats sont présentés dans le tableau 1 dans lequel 1µdef=10⁻⁶ mètre par mètre.

**Tableau 1**

| | MFC seul | Actionneur |
|---|---|---|
| (µdef) | 61 | 30 (-51%) |
| (µdef) | 49 | 27 (-45%) |
| γ mesure rosette (µdef) | 438 | 289 (-34%) |
| γ mesure optique (µdef) | 462 | 255 (-45%) |

### Exemple 2

Toujours dans le cadre d'un actionneur à trois couches, une variante de réalisation permet d'accroître le déplacement en cisaillement.

Cet actionneur est constitué des éléments suivants :

Au centre, est placé un tissu de 0.2 mm, par exemple de type taffetas, dont les fibres sont en matériau à haut module, comme en carbone HM. Cette couche de tissu est plane et a une trame et une chaîne orientées respectivement selon la direction X et la direction Y. La trame et la chaîne définissent un maillage de parallélogrammes juxtaposés.

Sur le dessus de toute la surface de ladite couche de tissu est placée une première couche plane active piézoélectrique apte à s'allonger ou se rétracter suivant la bissectrice des directions X et Y lorsqu'elle est alimentée en tension. Cette couche piézoélectrique est du même type que celle de l'exemple précédent. Elle génère donc un angle de cisaillement γ par rapport à la direction X.

Sur le dessous de toute la surface de ladite couche de tissu est placée une seconde couche plane active piézoélectrique identique à la première et orientée de la même façon.

Deux joints de colle sont disposés entre les trois couches pour les lier entre elles. Ces joints de colle ont une épaisseur réglée à 0.1 mm au moyen d'une grille textile souple et un module de Young approprié de sorte à transmettre au mieux le déplacement de cisaillement desdits actionneurs audit tissu composite.

La première zone de fixation est située sur une face extérieure de l'actionneur. Elle est orientée selon la trame du tissu et s'étend le long d'une extrémité selon la chaîne de ce même tissu.

La seconde zone de fixation est située sur l'autre face extérieure de l'actionneur. Elle est orientée selon la trame du tissu et s'étend le long de l'autre extrémité selon la chaîne de ce même tissu.

En fonctionnement, les deux couches planes actives piézoélectriques de cet actionneur sont alimentés simultanément par une même tension. Elles génèrent selon une même bissectrice des directions X et Y, dans le plan X-Y, une extension qui se transmet grâce aux joints de colle à la couche de tissu. Les parallélogrammes du maillage du tissu, sollicités suivant la même diagonale, se déforment. Cette déformation se transforme en un cisaillement γ comme dans l'exemple précédent. Là encore, les joints de colle sont peu sollicités et la résultante des forces mises en jeu est dans le plan X-Y.

Un tel actionneur a été fabriqué avec un tissu de carbone SXM10 pris en sandwich entre deux MFC de section active 85 × 57 × 0.3 mm³ servant de couches planes actives piézoélectriques et a été testé en fonctionnement avec les mêmes moyens de mesure et dans les mêmes conditions que dans l'exemple 1.

Les résultats sont présentés dans le tableau 2, dans lequel 1µdef=10⁻⁶ mètre par mètre.

**Tableau 2**

| | MFC seul | Actionneur |
|---|---|---|
| X (µdef) | 61 | 53 (-13%) |
| Y (µdef) | 49 | 42 (-14%) |
| γ mesure rosette (µdef) | 438 | 397 (-9%) |
| γ mesure optique (µdef) | 462 | 383 (-17%) |

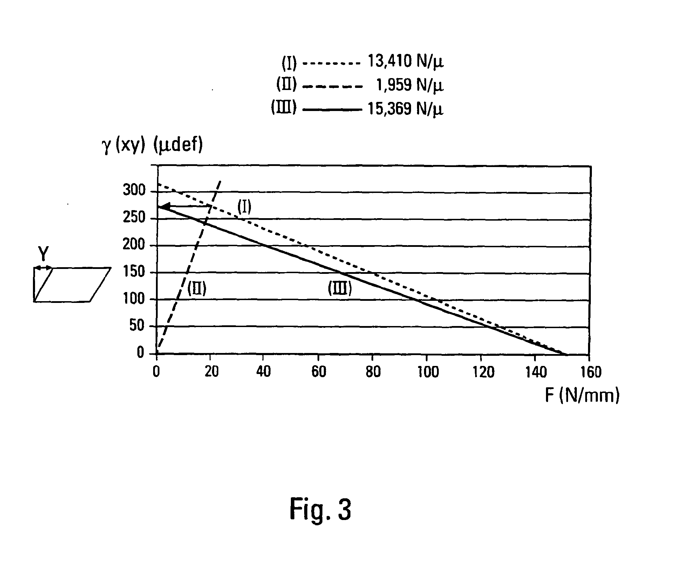

La figure 3 illustre une évaluation des performances d'un tel actionneur.

Pour les MFC nues, la courbe (I) est la droite de l'angle de cisaillement γ crête à crête mesuré sur une MFC alimentée sous +/-500V en fonction de la force de cisaillement F établie à partir de la pente de raideur calculée en cisaillement. Si γ = 0, la force de cisaillement est dite de blocage car elle est telle qu'elle fait perdre toute la course à vide qui est γmax (320µdéf) pour F=0.

Pour le tissu de carbone et les deux joints de colle, la courbe (II) est une droite exprimant la raideur en cisaillement de l'ensemble.

La courbe (III) caractérise l'actionneur qui est l'assemblage de la couche de tissu + colle avec les 2 MFC.

En complément à ces deux exemples, il est possible de mettre en oeuvre un nombre de couches planes plus important. Cependant, afin d'être conforme à l'invention la structure des différentes variantes réalisées doit satisfaire simultanément à plusieurs caractéristiques essentielles.

Tout d'abord, la structure doit être symétrique par rapport à un plan médian, ceci afin de favoriser une déformation en cisaillement plane de l'actionneur.

Ensuite, la trame et la chaîne de chaque couche plane de tissu qui définissent une maille en forme de parallélogramme, doivent toutes être orientées selon respectivement les deux mêmes directions de leur plan, parallèle au plan médian.

De plus, toutes les couches planes actives piézoélectriques doivent avoir, chacune dans leur plan, des directions actives parallèles et de même sens orientées selon la même diagonale de la maille en forme de parallélogramme.

Enfin, les deux zones de fixation doivent être situées aux extrémités opposées de la trame ou de la chaîne des couches de tissu et être disposées respectivement selon la direction de la chaîne ou de la trame des couches de tissu.

### Exemple 3

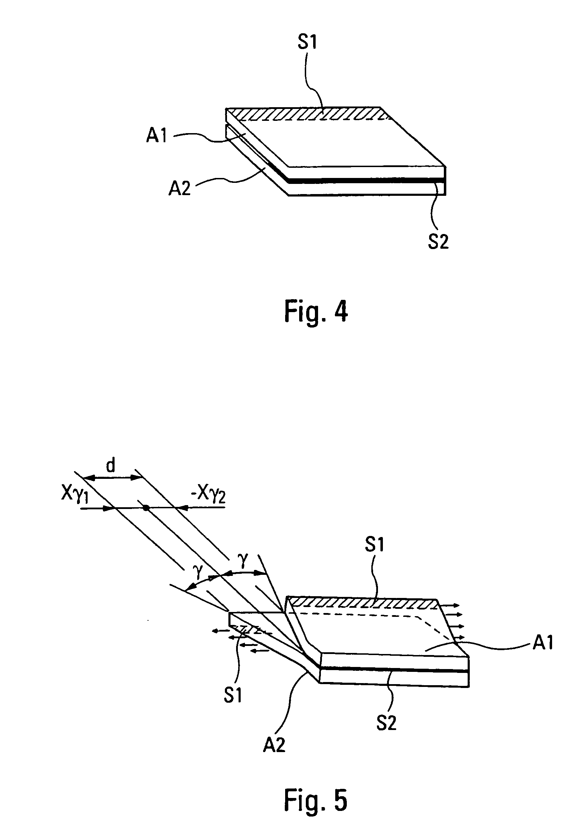

L'invention porte sur un dispositif composé de l'assemblage tête-bêche de deux actionneurs A1 et A2 identiques à l'actionneur A décrit dans les exemples précédents. Les deux actionneurs A1 et A2 sont montés comme indiqué sur la figure 4, l'un au-dessus de l'autre, parallèles l'un à l'autre et collés par leurs zones de fixation S2 respectives.

Le principe de fonctionnement de l'invention est que, lorsque le premier actionneur conforme à celui de l'exemple 1 ou 2 est activé, il génère dans le plan X-Y et à 45° une extension qui se transmet au tissu dont le maillage sollicité suivant la première diagonale se déforme en parallélogramme. Cette déformation se transforme en un cisaillement γ et le premier actionneur fournit un déplacement en cisaillement X_{γ1} = γ × W suivant l'axe X comme le montre la figure 5.

De même, lorsque le deuxième actionneur est activé, il génère dans le plan X-Y et à 135° une extension qui se transmet au tissu dont le maillage sollicité suivant la deuxième diagonale se déforme en parallélogramme. Cette déformation se transforme en un cisaillement -γ et le deuxième actionneur A2 fournit un déplacement en cisaillement X_{γ2} = -γ × W suivant l'axe X. Ce déplacement de cisaillement est opposé au déplacement de cisaillement du premier actionneur A1.

L'amplitude d du déplacement total de cisaillement du dispositif entre les zones de fixation S1 respectives est égale à la somme des amplitudes des déplacement de cisaillement de chaque actionneur, soit d= X_{γ1} - X_{γ2} et comme dans l'exemple les actionneurs sont identiques, d = 2γ x W comme indiqué sur la figure 5.

### Exemple 4

Un dispositif selon l'invention peut mettre en oeuvre une combinaison de deux actionneurs non strictement identiques. Par exemple, il est possible de combiner un premier actionneur conforme à l'exemple 1 avec un second actionneur ayant la même structure sandwich mais dont, d'une part, la largeur W suivant la direction Y est supérieure à celle du premier actionneur et dont, d'autre part, les deux zones de fixation sont situées sur la même face de ce second actionneur.

Le dispositif obtenu présente alors deux zones de fixation adjacentes accessibles par une seule face, ce qui peut présenter un intérêt pratique pour certaines applications.

Un dispositif selon l'invention peut être utilisé avantageusement en combinaison avec une structure de pale d'hélicoptère afin de lui faire subir une torsion selon l'envergure. Dans ces conditions, le système n'est plus strictement plan au cours de son fonctionnement mais est légèrement gauchi. Cependant cette déformation est faible localement et ne modifie pas fondamentalement le fonctionnement du dispositif décrit dans les exemples précédents.

### Exemple 5

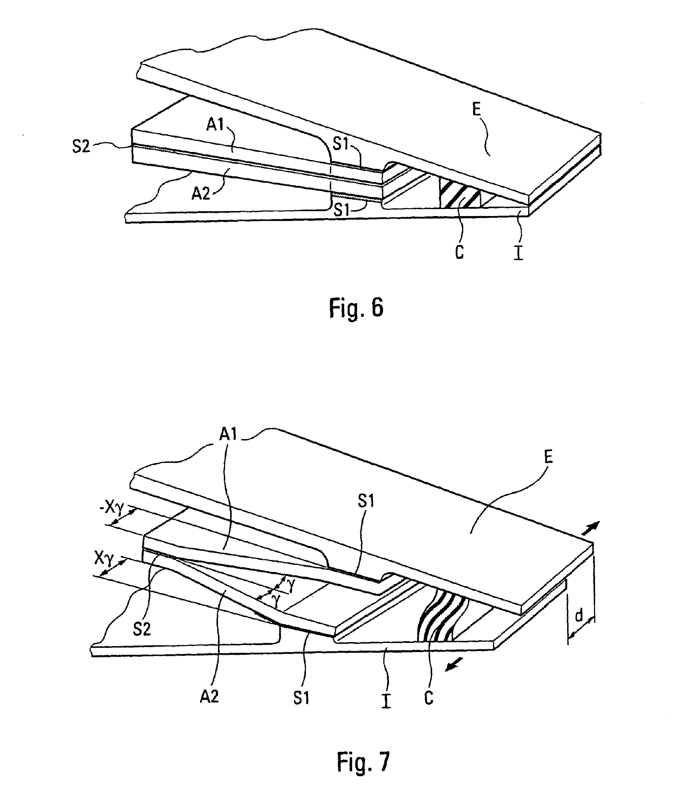

Comme montré sur la figure 6, le dispositif de l'invention peut être disposé à l'intérieur du profil d'une surface portante ouverte d'aéronef, et à proximité de ses bords de fuite. Une surface portante est dite ouverte lorsque l'intrados et l'extrados ne sont pas solidarisés entre eux à proximité du bord de fuite de la surface. Les bords de fuite extrados E et intrados I sont munis de renforts en vis-à-vis des zones de fixation S1 de A1 et de A2 du dispositif. Les bords de fuite sont collés, ou vissés, au niveau des renforts aux zones de fixation S1 de chacun des actionneurs identiques A1 et A2. Les collages ou vissages sont répartis suivant l'envergure, parallèle à l'axe X de la figure 5. Les zones S2 de A1 et de A2 et le bord de fuite sont situés, selon la corde, de part et d'autre des zones de fixation S1 de A1 et de A2 du dispositif à la voilure. Le plan de symétrie du dispositif au repos se situe au voisinage du plan de corde du profil, donc de l'axe neutre de flexion. Le dispositif n'est ainsi soumis qu'à de très faibles contraintes lorsque la pale est sollicitée en flexion.

Le dispositif referme continûment suivant l'envergure la section de la zone portante. Cependant, une liaison complémentaire peut être réalisée entre les bords de fuite intrados et extrados au moyen d'un élastomère C à faible module collé sur un renfort de chacun des bords de fuite, voire directement entre les zones de fixation S1 de A1 et de A2 du dispositif, car c'est la rigidité en cisaillement du dispositif qui conditionne la rigidité en torsion de la zone portante.

Le principe du dispositif ainsi implanté est identique à celui de l'exemple 2. L'amplitude d du déplacement total de cisaillement du dispositif entre les bords de fuite est égale à la somme des amplitudes des déplacement de cisaillement de chaque actionneur, comme indiqué sur la figure 7.

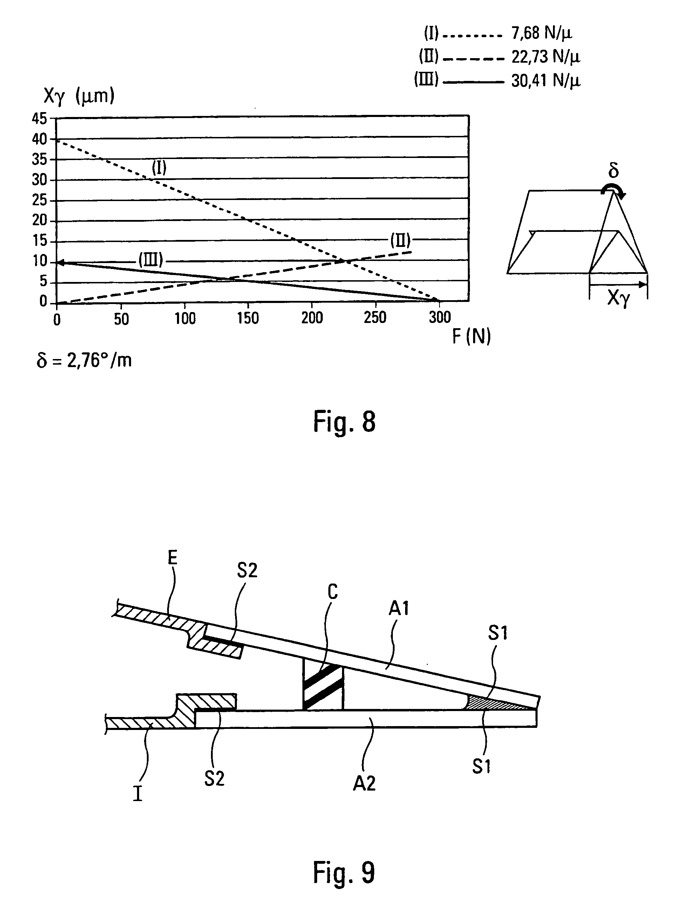

La figure 8 illustre une évaluation des performances d'un tel dispositif.
La courbe (I) caractérise le dispositif composé seulement des deux actionneurs simples en série définis précédemment. Les déplacements sont exprimés en µm. Le dispositif est alimenté sous +1500/-500 Volts ;
La courbe (II) caractérise la raideur en cisaillement d'une section de pale (corde 141.5 mm) ouverte au bord de fuite. La structure interne est de type classique. La force de cisaillement est celle qu'il faut appliquer au bords de fuite pour les déplacer l'un par rapport à l'autre ;
La courbe (III) caractérise l'assemblage pale et dispositif assemblés.

### Exemple 6

Comme montré sur la figure 9, le dispositif de l'invention peut intégrer le bord de fuite lui-même, les deux actionneurs constituant respectivement les parties de l'extrados et de l'intrados immédiatement voisines du bord de fuite. Les plans de symétrie des deux actionneurs ne sont plus parallèles. Les actionneurs A1 et A2 du dispositif sont assemblés par leurs zones de fixation S1 respectives de façon à former entre eux l'angle souhaité pour le bord de fuite de la pale. L'actionneur A1 est collé par sa zone de fixation S2 à l'extrados coté bord de fuite à la peau extrados E du profil aérodynamique et l'actionneur simple A2 est collé par sa zone de fixation S2 à l'intrados coté bord de fuite à la peau intrados I du profil aérodynamique. Les zones S1 et le bord de fuite sont situés, selon la corde, du même coté des zones de fixation S2 de A1 et de A2 du dispositif à la voilure.

En complément, une liaison entre les bords de fuite intrados et extrados peut être réalisée au moyen d'un élastomère C à faible module collé par exemple au niveau des faces intérieures du double actionneur.

Le dispositif referme continûment suivant l'envergure la section de la surface portante et réalise un assemblage « composite » de sorte à raidir l'actionneur pour éviter son flambage.

## Revendications

1. Actionneur plan à structure sandwich comportant deux zones de fixation (S1, S2) destinées à transmettre le déplacement relatif en cisaillement généré, et au moins trois couches planes superposées (1, 2, 3) comprenant au moins une couche d'un tissus dont la chaîne et la trame sont constituées de fibres rigides disposées selon deux directions du plan (X, Y), formant un maillage de parallélogrammes juxtaposés, et au moins une couche plane active piézoélectrique apte à s'allonger ou se rétracter selon une direction active, chaque face d'une couche étant collée sur toute sa surface à une face de la couche adjacente, **caractérisé en ce que** la structure sandwich est symétrique par rapport au plan médian de l'actionneur, favorisant une déformation plane en cisaillement, la direction active de chaque couche plane piézoélectrique est orientée selon une seule et même diagonale du maillage de chaque couche de tissus dont la chaîne et la trame sont toutes orientées selon les deux mêmes directions du plan (X, Y), les zones de fixation de l'actionneur (S1, S2), de forme allongée selon une première des deux directions du plan (X, Y), sont disposées le long des extrémités opposées de l'actionneur selon la seconde direction du plan (Y), ce grâce à quoi, chaque couche plane de tissus étant sollicitée selon une seule diagonale du maillage, les parallélogrammes se déforment entraînant le déplacement dans le plan des zones de fixation (S1, S2) parallèlement l'une à l'autre selon la première direction du plan (X).

2. Actionneur selon la revendication 1,
**caractérisé en ce que** la structure sandwich est constituée d'une couche active (1) située entre deux couches de tissus (2, 3).

3. Actionneur selon la revendication 1,
**caractérisé en ce que** la structure sandwich est constituée d'une couche de tissus (1) située entre deux couches actives (2, 3).

4. Dispositif actionneur plan,
**caractérisé en ce qu**'il est constitué de deux actionneurs conformes à l'une des revendications précédentes, montés tête-bêche, deux des zones de fixation en vis-à-vis des actionneurs étant solidarisées (S2) et les deux directions actives n'étant pas parallèles, les deux autres zones de fixation en vis-à-vis des actionneurs (Sl), laissées libres, ont un déplacement selon la première direction du plan (X) dont l'amplitude est égale à la somme des amplitudes des deux actionneurs élémentaires.

5. Utilisation du dispositif selon la revendication 4 en combinaison avec la structure d'une surface portante ouverte, les deux zones de fixation (S1) en vis-à-vis laissées libres sont solidaires respectivement de l'intrados (I) et de l'extrados (E), le dispositif fermant ainsi cette structure à proximité de son bord de fuite.

6. Utilisation selon la revendication 5,
c**aractérisée en ce que** les deux zones de fixation en vis-à-vis solidarisées (S2) et le bord de fuite sont situés, selon la corde, de part et d'autre des deux zones de fixation (S1) en vis-à-vis laissées libres.

7. Utilisation selon la revendication 5,
**caractérisée en ce que** les deux zones de fixation en vis-à-vis solidarisées (S1) et le bord de fuite sont situés, selon la corde, du même coté des deux zones de fixation en vis-à-vis laissées libres, les deux zones de fixation (S1) en vis-à-vis solidarisées constituant le bord de fuite de la surface portante.

## Claims

1. A flat, sandwich-structure actuator comprising two attachment zones (S1, S2) designed to transmit the relative shearing displacement generated, and at least three flat superposed layers (1, 2, 3) comprising at least one layer of a fabric whose warp and weft consist of rigid fibers disposed in two directions (X, Y) of the plane, forming a mesh of juxtaposed parallelograms, and at least one piezoelectric active flat layer capable of lengthening or retracting in an active direction, each face of a layer being bonded over its whole surface to a face of the adjacent layer, **characterized in that** the sandwich structure is symmetrical relative to the mid-plane of the actuator, promoting a flat shearing deformation, the active direction of each piezoelectric flat layer is oriented along one and the same diagonal of the mesh of each layer of fabric whose warp and weft are all oriented in the same two directions (X, Y) of the plane, the attachment zones (S1, S2) of the actuator, of elongated shape in a first of the two directions of the plane, are disposed along the opposite ends of the actuator in the second direction (Y) of the plane, thanks to which each flat layer of fabric being acted upon in a single diagonal of the mesh, the parallelograms deform causing the attachment zones (S1, S2) to displace in the plane parallel with one another in the first direction (X) of the plane.

2. The actuator as claimed in claim 1, **characterized in that** the sandwich structure consists of an active layer (1) situated between two layers of fabric (2, 3).

3. The actuator as claimed in claim 1, **characterized in that** the sandwich structure consists of one layer of fabric (1) situated between two active layers (2, 3).

4. A flat actuator device, **characterized in that** two actuators are provided as claimed in anyone of the preceding claims, mounted head-to-tail, two facing attachment zones (S2) of the actuators being fixedly attached and the two active directions not being parallel, the other two facing actuator attachment zones (S1), left free, have a displacement in the first direction (X) of the plane whose amplitude is equal to the sum of the amplitudes of the two basic actuators.

5. The use of the device as claimed in claim 4 in combination with the structure of an open airfoil, **characterized in that** the two facing attachment zones (S1) left free are fixedly attached respectively to the pressure surface (I) and the suction surface (E), the device thus closing this structure in the vicinity of its trailing edge.

6. The use as claimed in claim 5, **characterized in that** the two fixedly attached facing attachment zones (S2) and the trailing edge are situated, along the chord, on either side of the two facing attachment zones (S1) left free.

7. The use as claimed in claim 5, **characterized in that** the two fixedly attached facing attachment zones (S1) and the trailing edge are situated, along the chord, on the same side of the two facing attachment zones left free, the two fixedly attached facing attachment zones (S1) forming the trailing edge of the airfoil.

## Patentansprüche

1. Planarer Aktor mit Sandwich-Aufbau, umfassend zwei Befestigungsbereiche (S1, S2), die dazu bestimmt sind, die erzeugte relative Scherbewegung zu übertragen, und mindestens drei übereinanderliegende planare Schichten (1, 2, 3), die umfassen: mindestens eine Schicht aus einem Gewebe, dessen Kette und Schuss aus starren Fasern gebildet sind, die in zwei Richtungen der Ebene (X, Y) angeordnet sind und ein Netzwerk aus aneinandergrenzenden Parallelogrammen bilden, und mindestens eine planare aktive piezoelektrische Schicht, die geeignet ist, sich in einer aktiven Richtung auszudehnen oder zusammenzuziehen, wobei jede Seite einer Schicht über ihre gesamte Oberfläche an eine Seite der angrenzenden Schicht geklebt ist, **dadurch gekennzeichnet, dass** der Sandwich-Aufbau in Bezug auf die Mittelebene des Aktors symmetrisch ist, was eine planare Scherverformung begünstigt, dass die aktive Richtung jeder planaren piezoelektrischen Schicht entlang ein und derselben Diagonale des Netzwerks jeder Gewebeschicht ausgerichtet ist, deren Kette und Schuss jeweils in den beiden gleichen Richtungen der Ebene (X, Y) ausgerichtet sind, dass die Befestigungsbereiche des Aktors (S1, S2) mit in einer ersten der beiden Richtungen der Ebene (X, Y) langgestreckten Form entlang den gegenüberliegenden Enden des Aktors in der zweiten Richtung der Ebene (Y) angeordnet sind, wodurch sich, da jede planare Gewebeschicht in einer einzigen Diagonale des Netzwerks beansprucht wird, die Parallelogramme verformen, was zu einer Bewegung der Befestigungsbereiche (S1, S2) in der Ebene parallel zueinander in der ersten Richtung der Ebene (X) führt.

2. Aktor nach Anspruch 1,
**dadurch gekennzeichnet, dass** der Sandwich-Aufbau aus einer aktiven Schicht (1) gebildet ist, die zwischen zwei Gewebeschichten (2, 3) angeordnet ist.

3. Aktor nach Anspruch 1,
**dadurch gekennzeichnet, dass** der Sandwich-Aufbau aus einer Gewebeschicht (1) gebildet ist, die zwischen zwei aktiven Schichten (2, 3) angeordnet ist.

4. Planare Aktorvorrichtung,
**dadurch gekennzeichnet, dass** sie aus zwei Aktoren nach einem der vorhergehenden Ansprüche gebildet ist, die Kopf zu Fuß montiert sind, wobei, da zwei der einander gegenüberliegenden Befestigungsbereiche der Aktoren fest miteinander verbunden sind (S2) und die beiden aktiven Richtungen nicht parallel sind, die beiden anderen einander gegenüberliegenden, frei gelassenen Befestigungsbereiche der Aktoren (S1) eine Bewegung in der ersten Richtung (X) der Ebene aufweisen, deren Amplitude gleich der Summe der Amplituden der beiden elementaren Aktoren ist.

5. Verwendung der Vorrichtung nach Anspruch 4 in Kombination mit der Struktur einer offenen Tragfläche, wobei die beiden einander gegenüberliegenden, frei gelassenen Befestigungsbereiche (S1) mit der Blattunterseite (I) bzw. der Blattoberseite (E) fest verbunden sind, wodurch die Vorrichtung diese Struktur in der Nähe ihrer Austrittskante verschließt.

6. Verwendung nach Anspruch 5,
**dadurch gekennzeichnet, dass** die beiden einander gegenüberliegenden, befestigten Befestigungsbereiche (S2) und die Austrittskante entlang der Profilsehne zu beiden Seiten der zwei einander gegenüberliegenden, frei gelassenen Befestigungsbereiche (S1) angeordnet sind.

7. Verwendung nach Anspruch 5,
**dadurch gekennzeichnet, dass** die beiden einander gegenüberliegenden, befestigten Befestigungsbereiche (S1) und die Austrittskante entlang der Profilsehne an der gleichen Seite der zwei einander gegenüberliegenden, frei gelassenen Befestigungsbereiche angeordnet sind, wobei die beiden einander gegenüberliegenden, befestigten Befestigungsbereiche (S1) die Austrittskante der Tragfläche bilden.
